# EUROPEAN PATENT APPLICATION

(11) **EP 2 983 253 A2**
(43) Date of publication of application: **10.02.2016**
(21) Application number: 14192171.8
(22) Date of filing: 06.11.2014
(51) Int. Cl.: H01R 13/66, H01R 13/70, H03K 17/96

(54) **Power socket with touch switch function**

(30) Priority: 05.08.2014 TW 103213833 U
(71) Applicant: Changshu Inforay Technology Co., Ltd., Changshu City, Jiangsu 215500 (CN)
(72) Inventor: Tsou, Shih-Hao, 215500 Changshu City (CN)
(74) Representative: Chaillot, Geneviève

(57) **Abstract**

A touch power socket includes a case, a socket body, a cover, and a touch sensing module. The case has a shell and a fixing part. The shell has a containing space and an opening. The fixing part is disposed along the shell so as to expose the opening. The socket body has a carrier board, an electrical contacted socket unit, and a control module. The electrical contacted socket unit and the control module are electrically connected to each other and disposed on the carrier board. The carrier board is disposed opposite to the opening of the shell. The cover is connected to the fixing part of the case, and has a socket and a touch area. The socket is disposed corresponding to the electrical contacted socket unit of the socket body. The touch sensing module is electrically connected to the control module. The touch sensing module is corresponding to the touch area and disposed between the carrier board and the cover.

## Description

This application claims the benefit of priority based on Taiwan Patent Application No 103213833, filed on August 5, 2014, the contents of which are incorporated herein by reference in their entirety.

### CROSS-REFERENCES TO RELATED APPLICATIONS

Not applicable.

### BACKGROUND OF THE INVENTION

### Field of the Invention

The present invention relates to a power socket. More particularly, the present invention relates to a touch power socket that is capable of switching power supply by a touch means.

### Descriptions of the Related Art

Most of the electrical equipment or devices are able to be operated by electricity. The electric company provides the electricity (e.g., main power) into various buildings via power transmission systems and power distribution systems. In the buildings, there are power outlets to provide the electricity, so that electrical equipment or devices with plugs could obtain the electricity to be operated from the power outlets via the plugs.

However, not each power outlet is connected to the plug at any time, so that the idle power outlet exposes the socket on the outside. When users, especially children, accidentally insert metal objects into the socket, it would lead to a short circuit to burn the power outlet or cause a fire.

To this end, the industry launches a power outlet with a mechanical switch next to the socket for controlling power supply of the power outlet. However, the mechanical switch is a protruding object which increases the chance of foreign objects touch. In addition, there is a clear touch of the protruding object such that children more likely touch the protruding object for remaining considerable worries.

In view of this, it is important to provide a safer power outlet that could reduce the chance of inadvertently touch from users and children.

### SUMMARY OF THE INVENTION

An objective of the present invention is to provide a safer power socket that is capable of switching power supply by a touch means. The power socket could cease provide power to avoid inadvertently touch from users and children when not using.

To achieve the above objective, the present invention is to provide a touch power socket, which comprises a case, a socket body, a cover, and a touch sensing module. The case has a shell and a fixing part. The shell has a containing space and an opening. The fixing part is disposed along the shell for exposing the opening. The socket body has a carrier board, an electrical contacted socket unit, and a control module. The electrical contacted socket unit and the control module are disposed on the carrier board. The carrier board is disposed opposite to the opening of the shell. The electrical contacted socket unit and the control module are electrically connected to each other. The cover is coupled to the fixing part of the case, and has a touch area and a socket corresponding to the electrical contacted socket unit of the socket body. The touch sensing module is corresponding to the touch area of the cover, electrically connected to the control module, and disposed between the carrier board and the cover.

According to an embodiment of the present invention, the touch power socket further comprises a power supply module which is configured for providing direct current (DC) power. According to another embodiment of the present invention, the power supply module is replaced by a power switching module which is configured for receiving alternating current (AC) power and outputting DC power according to the AC power.

According to an embodiment of the present invention, the control module comprises a microprocessor and a switching unit. The microprocessor is electrically connected to the power supply module and the switching unit. The switching unit has an input terminal, an output terminal, and a control terminal. The output terminal is electrically connected to the electrical contacted socket unit. The control terminal is electrically connected to the microprocessor. The microprocessor is configured for controlling a switching status between the input terminal and the output terminal.

According to an embodiment of the present invention, the control module comprises a wireless transmission unit which is electrically connected to the microprocessor. The wireless is configured for transmitting or receiving a wireless signal.

According to an embodiment of the present invention, the control module comprises a current monitoring unit which is electrically connected to the input terminal of the switching unit and the microprocessor. The current monitoring unit is configured for outputting a current signal to the microprocessor according to a current value retrieved from the input terminal.

According to an embodiment of the present invention, the switching unit is a relay, a solid-state relay (SSR), or a triode for alternating current (TRIAC).

According to an embodiment of the present invention, the carrier board is a printed circuit board (PCB), a glass circuit board, or a flexible printing circuit board (FPCB).

According to an embodiment of the present invention, the carrier board comprises a first surface and a second surface opposite to the first surface. The first surface is disposed opposite to the cover. The control module is disposed on the second surface of the carrier board.

According to an embodiment of the present invention, the electrical contacted socket unit comprises a socket and an electrical contact. The socket which passes through the first and the second surfaces of the carrier board is configured for coupling a plug. The electrical contact is disposed on the second surface corresponding to the socket. The touch sensing module is disposed on the first surface of the carrier board.

According to an embodiment of the present invention, the carrier board comprises a through hole which passes through the first and the second surfaces. The electrical contacted socket unit comprises a box body, a socket, and an electrical contact. The box body which is disposed in the through hole has a first side and a second side. The first side of the box body crops out on the first surface. The second side of the box body crops out on the second surface. The socket is disposed on the first side of the box body. The electrical contact which is disposed in the box body crops out on the second side of the box body.

According to an embodiment of the present invention, the cover comprises a shield layer which is disposed on a side opposite to the socket body.

According to an embodiment of the present invention, the cover is made of at least one of plastic, Acrylic, or glass.

According to an embodiment of the present invention, the touch sensing module is a resistive touch sensing module, a capacitive touch sensing module, or an optics touch sensing module.

According to the above description, by using a touch means to control power supply from electrical contacted socket unit, the touch power socket according to the present invention can greatly reduce inadvertently touch from users and children such that home and electrical safety can be enhanced.

The detailed technology and preferred embodiments implemented for the subject invention are described in the following paragraphs accompanying the appended drawings for people skilled in this field to well appreciate the features of the claimed invention.

### BRIEF DESCRIPTION THE DRAWINGS

**FIG. 1** is a schematic view of an embodiment of a touch power socket;
**FIG. 2** is a block diagram of an embodiment of a circuit structure;
**FIG. 3** is a flow chart of an embodiment of a setting gesture;
**FIG. 4** is a block diagram of an embodiment of another circuit structure;
**FIG. 5** is a block diagram of an embodiment of another circuit structure;
**FIG. 6** is a schematic view of an embodiment of a socket body of a touch power socket; and
**FIG 7** is a block diagram of an embodiment of another circuit structure.

### DESCRIPTION THE PREFERRED EMBODIMENT

In the following description, this invention will be explained with reference to embodiments thereof. However, the description of these embodiments is only for purposes of illustration rather than limitation. It should be appreciated that in the following embodiments and attached drawings, elements unrelated to this invention are omitted from depictions; and dimensional relationships among individual elements in the attached drawings are illustrated only for ease of understanding, but not to limit the actual scale.

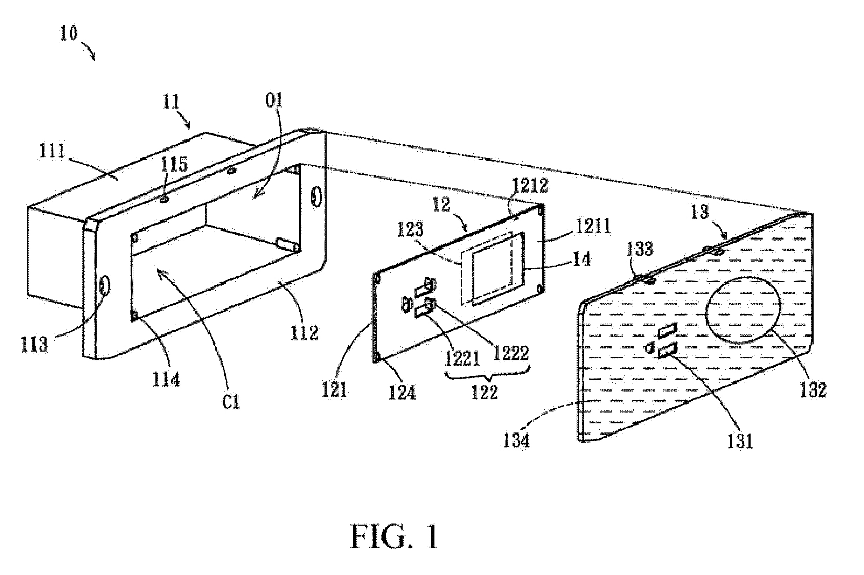

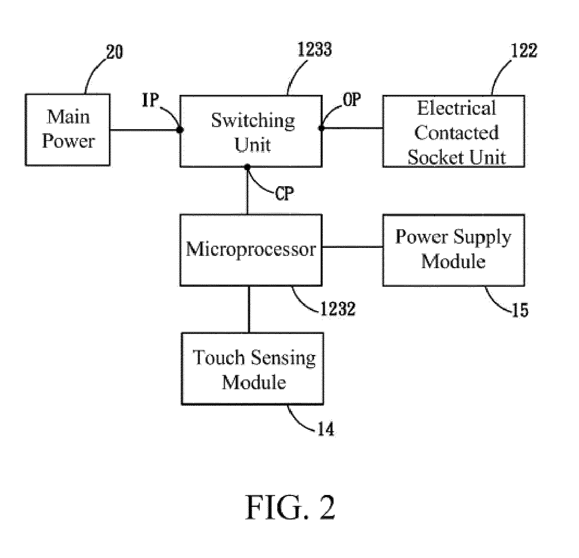

**FIG 1** and **FIG. 2** illustrate an embodiment of the present invention which is a touch power socket **10,** and it comprises a case **11,** a socket body **12,** a cover **13,** a touch sensing module **14,** and a power supply module **15.** In the embodiment, the touch power socket **10** can be inserted in a building structure, equipment, or a device. However, the present invention has no limitation on what the touch power socket **10** is inserted in, and those skilled in the art may insert the touch power socket **10** in any object with at least one opening depending on the practical needs; thus, this will not be further described herein.

The case **11** has a shell **111** and a fixing part **112.** In the embodiment, the case **11** can be made of plastic, metal, or Acrylic. In a preferred embodiment, the case **11** is made of metal, such as aluminium. The shell **111** which consists of four side walls and a bottom has a containing space **C1** and an opening **O1.** A hole (not shown) is set at the bottom of the shell **111** such that an electricity transmission line can pass through the shell **111.** The fixing part **112** is disposed along the shell **111** for exposing the opening **O1.**

In the embodiment, the case **11** further has a first connection part **113,** a second connection part **114,** and a third connection part **115.** The first connection part **113** consists of two holes which are individually disposed on two sides of the fixing part **112.** A corresponding fixing device passes through the first connection part **113** and is coupled and fixed to a surface of the building structure, the equipment, or the device. The second connection part **114** consists of four screw holes which are individually disposed on the four side walls of the shell **111.** The third connection part **115** is disposed on a surface of the fixing part **112.** The connection ways of the second connection part **114** and the third connection part **115** will be described in the following paragraphs.

The socket body **12** has a carrier board **121,** an electrical contacted socket unit **122,** and a control module **123.** The carrier board **121** which is disposed opposite to the opening **O1** of the shell **111** has a first surface **1211** and a second surface **1212.** The carrier board **121** can be a PCB, a glass circuit board, or an FPCB. It should be particularly noted that the carrier board **121** is not limited to be the PCB, the glass circuit board, or the FPCB in the present invention. Those of ordinary skill in the art may select different boards to be the carrier board **121** depending on practical requirements. The electrical contacted socket unit **122** and the control module **123** are electrically connected to each other by circuit traces on the carrier board **121.**

The socket body **12** further has a fourth connection part **124** which is coupled to the second connection part **114** by latches, magnetism, or screws. In the embodiment, the fourth connection part **124** is coupled to the second connection part **114** by screws such that the socket body **12** is stably coupled to the case **11** via the opening **O1.**

The electrical contacted socket unit **122** comprises a socket **1221** and an electrical contact **1222.** The socket **1221 is** a through hole throughout the first surface **1211** and the second surface **1212** of the carrier board **121.** The electrical contact **1222** which is disposed on one side of the second surface **1212** of the carrier board **121** corresponding to the socket **1221** is electrically connected to main power **20** (shown in **FIG. 2**). In the embodiment, the socket **1221** which has three through holes couples to a plug (not shown). More specifically, metal parts of the plug are electrically connected to the electrical contact **1222** such that the main power **20** is transmitted to the plug via the electrical contact **1222.**

In the embodiment, the control module **123** and the power supply module **15** are disposed on the second surface **1212** of the carrier board **121,** and are electrically connected to each other. The control module **123** is further electrically connected to the electrical contacted socket unit **122** via the circuit traces on the carrier board **121.** As shown in **FIG. 2****,** the control module **123** has a microprocessor **1232** and a switching unit **1233.**

The power supply module **15** provides power to the units of the control module **123** which is driven by electricity. In the embodiment, the power supply module **15** is a battery which provides DC power to the microprocessor **1232.** In another embodiment, the power supply module **15** provides DC power to the touch sensing module **14.** The microprocessor **1232** is electrically connected to the power supply module **15** and the switching unit **1233.** In addition, the microprocessor **1232** has an input terminal **IP,** an output terminal **OP,** and a control terminal **CP.** The output terminal **OP** is electrically connected to the electrical contacted socket unit **122.** The control terminal **CP** is electrically connected to the microprocessor **1232.** The microprocessor **1232** controls a switching status, such as closed or open, between the input terminal **IP** and the output terminal **OP.** The switching unit **1233** can be a relay, an SSR, or a TRIAC. In the embodiment, the switching unit **1233** is a relay.

The cover **13** which is made of at least one of plastic, Acrylic, and glass has a socket **131** and a touch area **132.** The socket **131** is corresponding to the socket **1221** of the electrical contacted socket unit **122** of the socket body **12.** More specifically, the plug is electrically connected to the electrical contact **1222** via the socket **131** and the socket **1221.** The touch area **132** can be a plane, a convex, or a concave. It should be particularly noted that the touch area **132** is not limited to be the plane, the convex, or the concave in the present invention. When the touch area **132 is** the convex or the concave, there is a clear touch of the touch area **132** such that a user is clearly understanding of where the touch area is located.

The cover **13** further has a fifth connection part **133** which is disposed on one side of the cover **13** opposite to the fixing part **112** of the case **11.** The fifth connection part **133** is coupled to the third connection part **115** by latches, magnetism, or screws. In the embodiment, the fifth connection part **133** is coupled to the third connection part **115** by latches, such as a hook and a slot.

The cover **13** further has a shield layer **134** which is disposed on one side of the cover **13** opposite to the socket body **12.** The shield layer **134** is made of low translucent material or opaque material, such as printing ink. Therefore, a user is difficult to perceive the socket body **12** and other components to achieve beautiful results when viewing the touch power socket **10** from one side of the touch area **132.**

The touch sensing module **14** can be a resistive touch sensing module, a capacitive touch sensing module, or an optics touch sensing module. The touch sensing module **14** is corresponding to the touch area **132** of the cover **13,** electrically connected to the microprocessor **1232** of the control module **123,** and disposed between the carrier board **121** and the cover **13.** In the embodiment, the touch sensing module **14** is a capacitive touch sensing module. More specifically, when the touch sensing module **14** is a capacitive touch sensing module, the touch area **132** of the cover **13** is a concave to shorten a distance between fingers of a user and the touch sensing module **14** for increasing touch sensitivity of the touch sensing module **14.**

In addition, the touch sensing module **14** is disposed on the first surface **1211** of the carrier board **121.** A main part of the touch sensing module **14** is a transparent conductive film which is made of copper, indium tin oxide (ITO), or carbon nanotubes (CNTs).

According to the above description, the touch power socket **10** of the present invention is a power outlet in accordance with the International Electrotechnical Commission (IEC) standard. In addition, the touch power socket **10** has the same size as the current power outlet such that the touch power socket **10** can easily replace the current power outlet. Therefore, users can cease power supply from the touch power socket **10** by a touch means to reduce inadvertently touch from users for enhancing home and electrical safety when not using the touch power socket **10.**

Further, in addition to controlling power supply by a simple touch means, the power supply can be controlled by a touch gesture means for enhancing home and electrical safety. More specifically, the use of more complex touch gestures to control power supply will reduce inadvertently touch for effectively enhancing home and electrical safety.

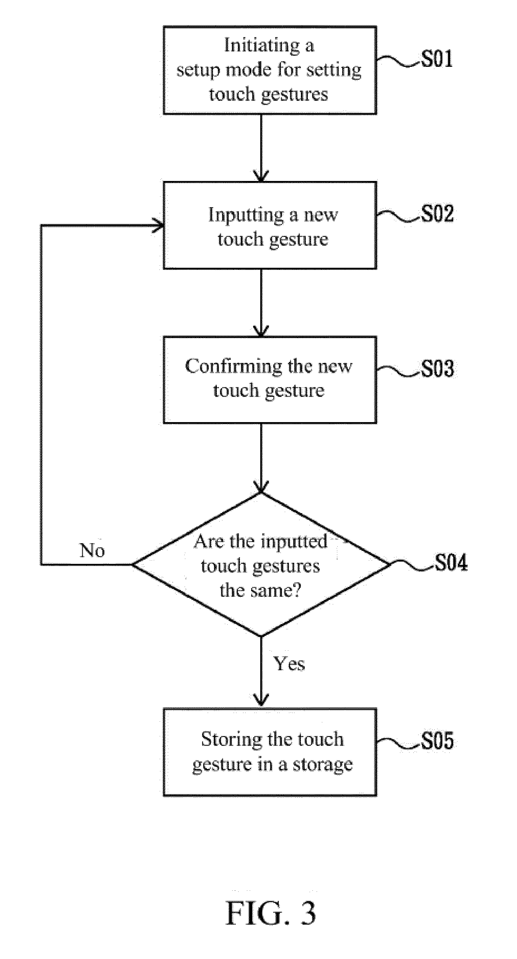

In practical applications, the user can customize settings of the touch gestures. **FIG. 3** illustrates the method for the user customizing settings of the touch gestures, which comprises the following steps.

Initially in step **S01,** a setup mode for setting the touch gestures is initiated. For example, the setup mode for setting the touch gestures is initiated by long pressing the touch area **132** at a predetermined period (e.g. 3 seconds or 5 seconds), or continuously touching the touch area **132** at the predetermined period.

In step **S02,** a new touch gesture is inputted by the user. According to needs, the user can input the touch gesture, such as a sliding direction, a number of clicks, or a combination thereof.

In step **S03,** the touch power socket **10** prompts the user to confirm the touch gesture. For example, the touch power socket **10** prompts the user to input the touch gesture which is inputted in step **S02** once again by an audible prompt, a voice prompt, or a light-emitting tip.

In step **S04,** the microprocessor **1232** compares the touch gesture which is inputted in step **S02** with the touch gesture which is inputted in step **S03.** When the touch gestures which are inputted in step **S02** and step **S03** are the same, the step **S05** is executed for storing the touch gesture in a storage. When the touch gesture which is inputted in step **S02** is different from the touch gesture which is inputted in step **S03,** the step **S02** is executed for the user re-inputting a new touch gesture.

In the embodiment, the storage is disposed in the microprocessor **1232.** It should be particularly noted that the storage is not limited to be disposed in the microprocessor **1232** in the present invention. Those of ordinary skill in the art may dispose an independent unit as the storage depending on practical requirements.

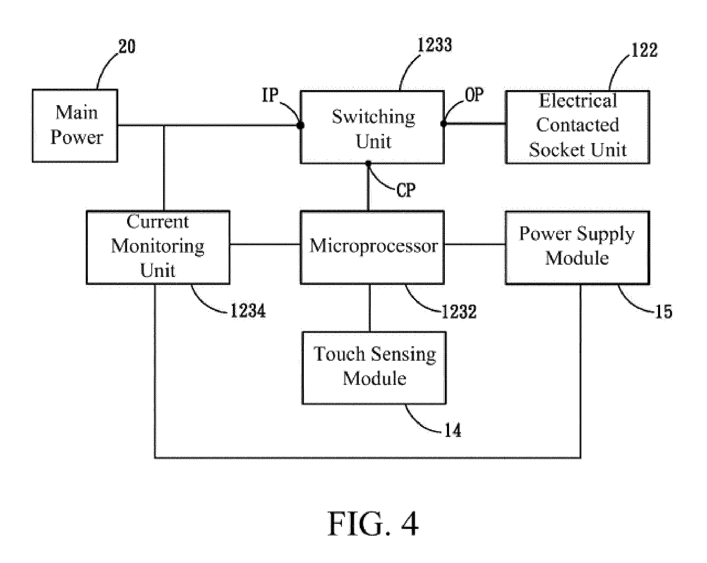

Referring to **FIG. 4****,** the control module **123** of the touch power socket **10** further has a current monitoring unit **1234** which is electrically connected to the microprocessor **1232,** the switching unit **1233,** and the power supply module **15.** More specifically, the current monitoring unit **1234** is electrically connected to the input terminal **IP** of the switching unit **1233** for retrieving a current value (i.e. loading current) from the input terminal **IP,** and outputs a current signal to the microprocessor **1232** according to the loading current. When the loading current is greater than a predetermined value, the microprocessor **1232** controls a switching status as open between the input terminal **IP** and the output terminal **OP** of the switching unit **1233** for ceasing provide power.

General electrical overload protection is performed by no fuse breakers disposed in a distribution box. However, after a no fuse breaker is operated, power lines arranged in the building structure is hot due to an overload. When aging due to time, carrying capacity of the power lines will decline such that the above hot condition may cause electrical fire. Therefore, retrieving the loading current and outputting the current signal according to the loading current by the current monitoring unit **1234** are able to enhance the safety on the power lines arranged in the building structure.

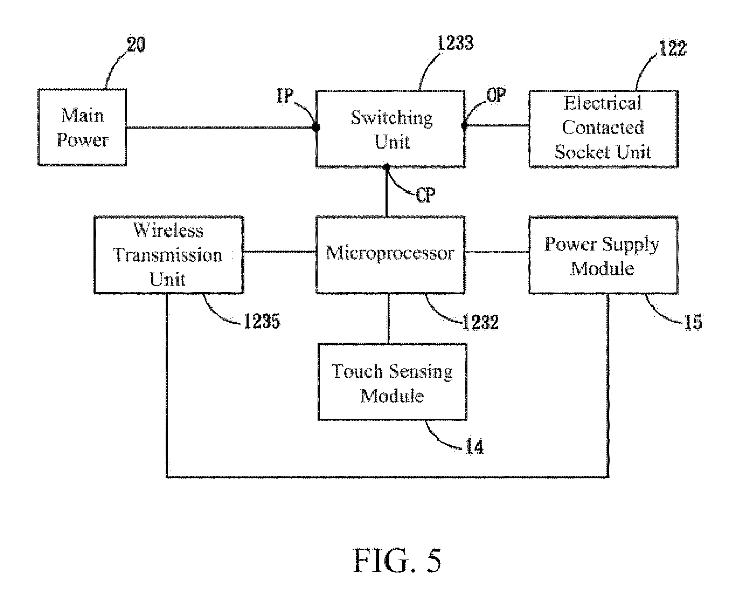

Referring to **FIG. 5****,** the control module **123** of the touch power socket **10** further has a wireless transmission unit **1235** which is electrically connected to the microprocessor **1232** and the power supply module **15.** The wireless transmission unit **1235** transmits or receives at least one wireless signal. The wireless transmission unit **1235** can be wirelessly connected to a wireless base station, a mobile communication device, or a terminal for transmitting the wireless signal. In the embodiment, the wireless transmission unit **1235** which is wirelessly connected to the mobile communication device transmits the switching status (e.g. closed or open) or the settings (e.g. touch gestures) of the touch power socket **10** to the mobile communication device such that the user can understand a state of the touch power socket **10.** In addition, the user can change the switching status or the settings of the touch power socket **10.** Therefore, the nearby touch power sockets can be controlled by the user via the mobile communication device. Further, the user can monitor a loading status of each touch power socket with the current monitoring unit **1234** via the mobile communication device.

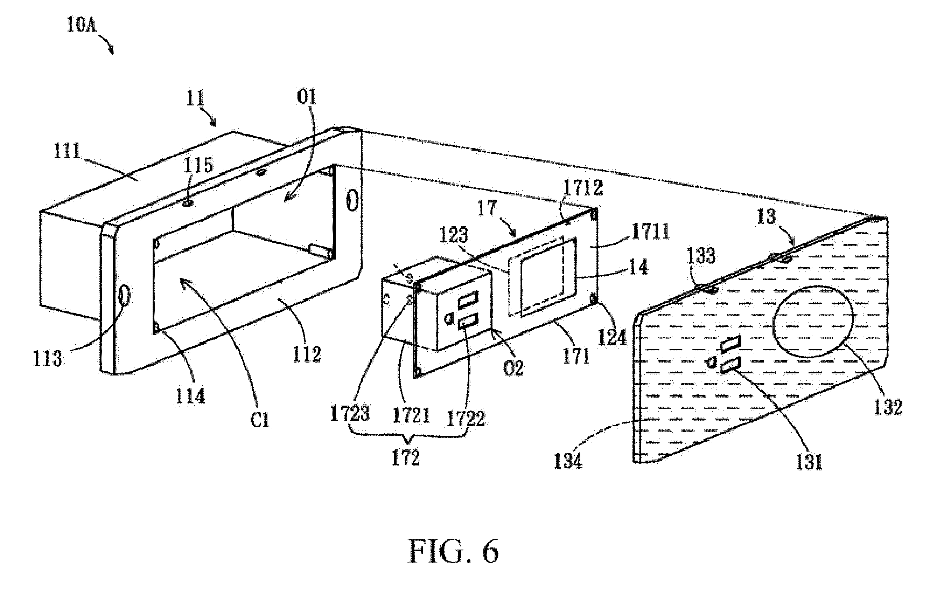

**FIG. 6** illustrates an embodiment of the present invention which is a touch power socket **10A,** and it is similar to the touch power socket **10** illustrated in **FIG. 1** and **FIG. 2****.** In the touch power socket **10A,** the socket body **12** of the touch power socket **10** is replaced by a socket body **17.** The socket body **17** has a carrier board **171,** an electrical contacted socket unit **172,** and the control module **123.** The carrier board **171** has a first surface **1711,** a second surface **1712,** and a through hole **02.** The through hole **02** passes through the first surface **1711** and the second surface **1712.** The electrical contacted socket unit **172** comprises a box body **1721,** a socket **1722** and an electrical contact **1723.** The box body **1721** which is disposed in the through hole **02** has a first side cropping out on the first surface **1711** and a second side cropping out on the second surface **1721.** The socket **1722** is disposed on and crops out the first side of the box body **1721.** The electrical contact **1723** which is disposed in the box body **1721** crops out on the second side of the box body **1721.** Therefore, the electrical contacted socket unit **172** is an independent unit which can be coupled to the carrier board **171** through the through hole **02** by latches or bonding.

In the above embodiments, the power supply module (e.g. battery) provides DC power to each electrical unit (e.g. microprocessor, wireless transmission unit, current monitoring unit, or touch sensing module) which is driven by DC power. However, each electrical unit can be driven by another power supply means which is described in the following paragraphs.

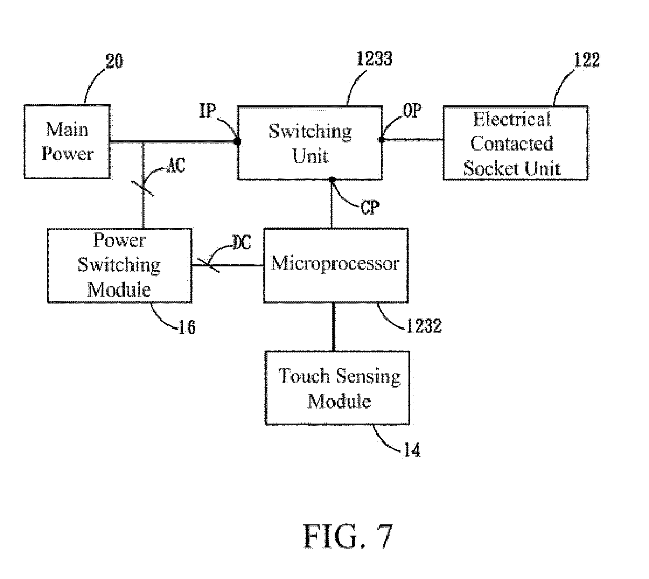

Referring to **FIG. 7****,** the power supply module is a power switching module **16.** The power switching module **16** is electrically the main power **20** and receives AC power from the main power **20.** After receiving the AC power from the main power **20,** the power switching module **16** switches the AC power into DC power, and outputs the DC power to the microprocessor **1232** such that the microprocessor **1232** is driven by the DC power. In the embodiment, the power switching module **16** has an adaptor (not shown). Further, the power switching module **16** has a DC/DC converter (not shown) for switching the DC power into various voltages and outputting the various voltages.

In addition, the power switching module **16** provides DC power to other electrical units (e.g. current monitoring unit, wireless transmission unit, and touch sensing module) of the touch power socket which is driven by the DC power.

According to the above description, users can cease power supply from the touch power socket of the present invention by a touch means to reduce inadvertently touch from users or children for enhancing home and electrical safety. Further, the power supply can be controlled by more complex touch gestures to effectively reduce inadvertently touch. In addition, by using the wireless transmission unit, the switching status of the touch power socket of the present invention can be easily confirmed by remote monitoring such that the touch power socket without using can be ensured at the open status. Finally, by using the current monitoring unit, the loading status of the touch power socket of the present invention can be controlled. More specifically, when the loading current of the touch power socket is greater than a predetermined value, the power supply from the touch power socket can be ceased for enhancing electrical safety.

The above embodiments merely give the detailed technical contents of the present invention and inventive features thereof, and are not to limit the covered range of the present invention. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A touch power socket, comprising:
a case having a shell and a fixing part, wherein the shell has a containing space and an opening, and the fixing part is disposed along the shell for exposing the opening;
a socket body having a carrier board disposed opposite to the opening of the shell, an electrical contacted socket unit disposed on the carrier board, and a control module disposed on the carrier board, wherein the electrical contacted socket unit and the control module are electrically connected to each other;
a cover, coupled to the fixing part of the case, having a touch area and a socket corresponding to the electrical contacted socket unit of the socket body; and
a touch sensing module corresponding to the touch area of the cover, wherein the touch sensing module is electrically connected to the control module and disposed between the carrier board and the cover.

2. The touch power socket as claimed in claim 1, the control module comprising:
a microprocessor electrically connected to the touch sensing module; and
a switching unit having an input terminal, an output terminal electrically connected to the electrical contacted socket unit, and a control terminal electrically connected to the microprocessor,
wherein the microprocessor is configured for controlling a switching status between the input terminal and the output terminal.

3. The touch power socket as claimed in claim 2, the control module further comprising a wireless transmission unit electrically connected to the microprocessor.

4. The touch power socket as claimed in claim 2, the control module further comprising a current monitoring unit, electrically connected to the input terminal of the switching unit and the microprocessor, being configured for outputting a current signal to the microprocessor according to a current value of the input terminal.

5. The touch power socket as claimed in claim 2, wherein the switching unit is one of a relay, a solid-state relay (SSR), and a triode for alternating current (TRIAC).

6. The touch power socket as claimed in claim 2, further comprising a power supply module being configured for providing direct current (DC) power to the microprocessor.

7. The touch power socket as claimed in claim 2, further comprising a power switching module being configured for receiving alternating current (AC) power and outputting DC power to the microprocessor according to the AC power.

8. The touch power socket as claimed in claim 1, wherein the carrier board is one of a printed circuit board (PCB), a glass circuit board, and a flexible printing circuit board (FPCB).

9. The touch power socket as claimed in claim 1, the carrier board comprising a first surface and a second surface opposite to the first surface, wherein the first surface is disposed opposite to the cover, and the control module is disposed on the second surface.

10. The touch power socket as claimed in claim 9, the electrical contacted socket unit comprising:
a socket throughout the first and the second surfaces of the carrier board; and
an electrical contact disposed on the second surface corresponding to the socket.

11. The touch power socket as claimed in claim 9, the carrier board further comprising a through hole passing through the first and the second surfaces, and the electrical contacted socket unit comprising:
a box body, disposed in the through hole, having a first side cropping out on the first surface and a second side cropping out on the second surface;
a socket disposed on the first side of the box body; and
an electrical contact disposed in the box body and cropping out on the second side.

12. The touch power socket as claimed in claim 9, wherein the touch sensing module is disposed on the first surface of the carrier board.

13. The touch power socket as claimed in claim 1, the cover further comprising a shield layer disposed on a side opposite to the socket body.

14. The touch power socket as claimed in claim 1, wherein the cover is made of at least one of plastic, Acrylic, or glass.

15. The touch power socket as claimed in claim 1, wherein the touch sensing module is one of a resistive touch sensing module, a capacitive touch sensing module, and an optics touch sensing module.
